# EUROPEAN PATENT APPLICATION

(11) **EP 4 604 185 A1**
(43) Date of publication of application: **20.08.2025**
(21) Application number: 22964533.8
(22) Date of filing: 02.11.2022
(51) Int. Cl.: H01L 33/44, H01L 33/36, H01L 25/075, H01L 27/12

(54) **SEMICONDUCTOR LIGHT EMITTING ELEMENT AND DISPLAY DEVICE**

(71) Applicant: LG Electronics Inc., Yeongdeungpo-gu Seoul 07336 (KR)
(72) Inventor: KWON, Taein, Seoul 06772 (KR); KIM, Myoungsoo, Seoul 06772 (KR); KIM, Jungsub, Seoul 06772 (KR)
(74) Representative: Vossius & Partner Patentanwälte Rechtsanwälte mbB
(86) International application number: PCT/KR2022/016986
(87) International publication number: WO 2024/096154

(57) **Abstract**

The semiconductor light-emitting element may include a light-emitting layer having a first region and a second region surrounding the first region, a first electrode on an upper side of the first region, a second electrode on an upper side of the second region, a passivation layer surrounding the light-emitting layer, and a metal oxide layer on a lower side of the light-emitting layer. A thickness of the metal oxide layer may be smaller than a thickness of the passivation layer.

## Description

### [Technical Field]

The embodiment relates to a semiconductor light-emitting element and a display device.

### [Background Art]

A large-area display includes a liquid crystal display (LCD), an OLED display, and a micro-LED display.

A micro-LED display is a display that uses micro-LEDs, each of which is a semiconductor light-emitting element having a diameter or cross-sectional area of 100*µ*m or less, as a display element.

Since a micro-LED display uses the micro-LEDs each of which is a semiconductor light-emitting element, as the display element, it has excellent performance in many characteristics such as contrast ratio, response speed, color reproducibility, viewing angle, brightness, resolution, lifespan, luminous efficiency, or luminance.

In particular, a micro-LED display has the advantage of being able to freely adjust the size or resolution by separating and combining the screen in a modular manner, and the advantage of being able to implement a flexible display.

However, since a large micro-LED display requires millions or more micro-LEDs, there is a technical problem that makes it difficult to quickly and accurately transfer micro-LEDs to the display panel.

Recently developed transfer technology includes the pick and place process, the laser lift-off method, and the self-assembly method.

Among these, the self-assembly method is a method in which semiconductor light-emitting elements find their assembly positions within a fluid, which is advantageous for implementing a large-screen display device.

However, research on the technology for manufacturing displays through self-assembly of micro-LEDs is still insufficient.

In particular, in the case of rapidly transferring millions or more semiconductor light-emitting elements to a large display in a conventional technology, the transfer speed can be improved, but the transfer error rate may increase, which causes a technical problem in that the transfer yield decreases.

In the related technology, a self-assembly transfer process using dielectrophoresis (DEP) is being attempted, but there is a problem of low self-assembly rate due to unevenness of DEP force, etc.

Meanwhile, a lateral-type semiconductor light-emitting element has the advantage of easy electrical connection because the anode and cathode electrodes are disposed on the upper side. However, as a lateral-type semiconductor light-emitting element is reduced to micrometer size for use as a pixel (or subpixel) for display, the light luminance thereof is decreasing, and various methods are being studied to solve this problem.

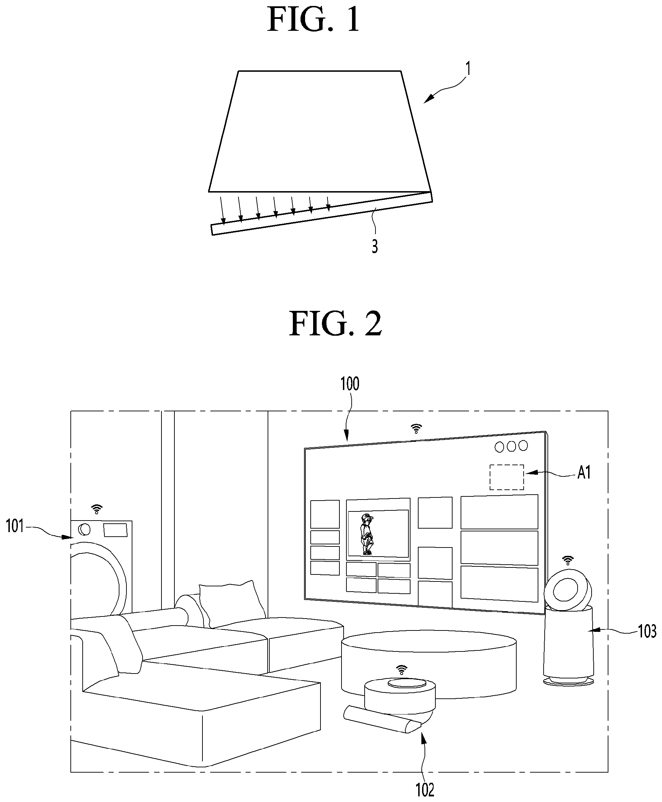

As illustrated in FIG. 1, a method has been proposed to improve light luminance through light reflection by disposing a reflective layer 3 such as Al, Ag, or APC (Ag-Pd-Cu) on a lower side of a lateral-type semiconductor light-emitting elements 1.

However, since the reflective layer 3 is made of metal, a lateral-type semiconductor light-emitting element 1 is adsorbed on the surface of the substrate during self-assembly, which reduces the assembly rate. That is, through the self-assembly process, each of the numerous lateral-type semiconductor light-emitting elements 1 must be assembled in the correct position. However, due to the reflection layer 3 of the lateral-type semiconductor light-emitting element 1, the lateral-type semiconductor light-emitting element 1 may be assembled in a position other than the correct position on the substrate, which reduces the assembly rate. In addition, the lateral-type semiconductor light-emitting element 1 assembled in the incorrect position is not electrically connected, which causes a lighting defect.

In addition, the binding force between the reflection layer 3 and the epi layer (semiconductor layer) in the lateral-type semiconductor light-emitting element 1 is very weak, and as numerous lateral-type semiconductor light-emitting elements 1 collide with each other during self-assembly, the binding force between the reflection layer 3 and the epi layer (semiconductor layer) becomes even weaker, so that the reflection layer 3 is peeled off from the epi layer (semiconductor layer). Thus, it causes defect in the lateral-type semiconductor light-emitting element 1 itself or defect in product such as display device.

Meanwhile, in order to increase the response speed by the magnet during self-assembly, a metal layer such as titanium (Ti) may be provided on the lower side of the lateral-type semiconductor light-emitting element. However, since the metal layer such as titanium (Ti) has excellent light absorption ability, there is a problem that the light reflectance is reduced. For example, it has been reported that more than 70% of the light directed toward the metal layer such as titanium (Ti) is absorbed.

Therefore, the development of a lateral-type semiconductor light-emitting element that may improve the assembly rate during self-assembly and minimize light absorption is urgently needed.

Meanwhile, no layer may be provided on the lower side of the lateral-type semiconductor light-emitting element. In this instance, the epi layer (semiconductor layer) is exposed to the etchant during the manufacturing process of the lateral-type semiconductor light-emitting element, and the epi layer (semiconductor layer) is damaged by the etchant. Accordingly, as the electrical characteristics or optical characteristics of the lateral-type semiconductor light-emitting element are deteriorated, there is a problem that the light luminance of the display device is reduced.

### [Disclosure]

### [Technical Problem]

An object of the embodiment is to solve the foregoing and other problems.

Another object of the embodiment is to provide a semiconductor light-emitting element and a display device capable of improving light luminance.

In addition, another object of the embodiment is to provide a semiconductor light-emitting element and a display device capable of solving an adsorption problem during self-assembly.

In addition, another object of the embodiment is to provide a semiconductor light-emitting element and a display device capable of improving an assembly rate.

The technical problems of the embodiments are not limited to those described in this item and include those that may be understood through the description of the invention.

### [Technical Solution]

According to one aspect of the embodiment, in order to achieve the above or other objects, a semiconductor light-emitting element, comprising: a light-emitting layer having a first region and a second region surrounding the first region; a first electrode on an upper side of the first region; a second electrode on an upper side of the second region; a passivation layer surrounding the light-emitting layer; and a metal oxide layer on a lower side of the light-emitting layer; and a thickness of the metal oxide layer is smaller than a thickness of the passivation layer.

The thickness of the metal oxide layer may be 1/3 or less of the thickness of the passivation layer.

The metal oxide layer may comprise a conductive oxide layer. The metal oxide layer may comprise a dielectric oxide layer.

The metal oxide layer may comprise a conductive oxide layer; and a dielectric oxide layer.

The conductive oxide layer may be disposed on the lower side of the light-emitting layer, and the dielectric oxide layer may be disposed on a lower side of the conductive oxide layer. The dielectric oxide layer may have a plurality of grooves.

The dielectric oxide layer may be disposed on the lower side of the light-emitting layer, and the conductive oxide layer may be disposed on a lower side of the dielectric oxide layer. The conductive oxide layer may have a plurality of grooves.

The metal oxide layer may comprise a plurality of first metal oxide layers; and a plurality of second metal oxide layers between the plurality of first metal oxide layers. A sum of a total thickness of the plurality of first metal oxide layers and a total thickness of the plurality of second metal oxide layers may be less than or equal to 1/2 of the thickness of the passivation layer.

The metal oxide may be disposed on a lateral part of the light-emitting layer. The metal oxide may be horizontally overlapped with the passivation layer.

According to another aspect of the embodiment, a display device, comprising: a substrate; a reflecting plate on the substrate; an adhesive layer on the reflecting plate; a plurality of semiconductor light-emitting elements emitting different color light on the adhesive layer; and a first electrode wiring and a second electrode wiring on an upper side of each of the plurality of semiconductor light-emitting elements, wherein the first electrode wiring and the second electrode wiring may be connected to a first electrode and a second electrode, respectively, of each of the plurality of semiconductor light-emitting elements.

### [Advantageous Effects]

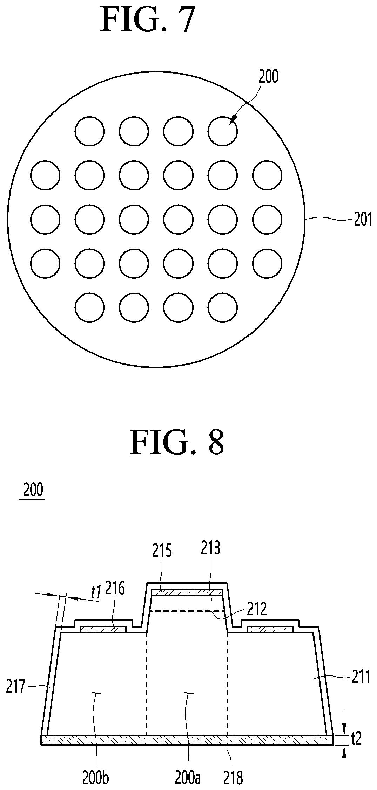

According to an embodiment, as illustrated in FIG. 8, a metal oxide layer 218 may be provided on a lower side of a semiconductor light-emitting element 200, and a thickness t2 of the metal oxide layer 218 may be made smaller than a thickness t1 of the passivation layer 217. The semiconductor light-emitting element 200 may be a lateral-type semiconductor light-emitting element. Accordingly, during self-assembly, the lower side of the semiconductor light-emitting element 200 may be subject to an attractive force rather than a repulsive force by the DEP force, and an upper side of the semiconductor light-emitting element 200 may be subject to a repulsive force rather than an attractive force. Therefore, during self-assembly, the semiconductor light-emitting element 200 may be properly assembled without being flipped over, thereby preventing lighting defect.

According to an embodiment, when a reflective layer as a metal substrate is disposed on a lower side of a lateral-type semiconductor light-emitting element in a non-public internal technology, the problem of the lateral-type semiconductor light-emitting element being absorbed on a backplane substrate by the reflective layer and thus the assembly rate being reduced may be solved. That is, according to the embodiment, since the metal oxide layer 218 having hydrophilicity is provided on the lower side of the semiconductor light-emitting element 200, the semiconductor light-emitting element 200 may be not adsorbed to a surface of the backplane substrate by the metal oxide layer 218 during self-assembly, so that the assembly rate can be improved.

According to an embodiment, when a metal layer such as Ti is disposed on the lower side of a lateral-type semiconductor light-emitting element to increase the response speed to a magnet during self-assembly in a non-public internal technology, the problem of the light extraction efficiency being reduced due to the metal layer absorbing most of the light traveling downward may be solved. That is, according to an embodiment, as illustrated in FIG. 8, by providing a metal oxide layer 218 on the lower side of a semiconductor light-emitting element 200 and making the thickness t2 of the metal oxide layer 218 smaller than the thickness t1 of the passivation layer 217, light may be transmitted instead of absorbed.

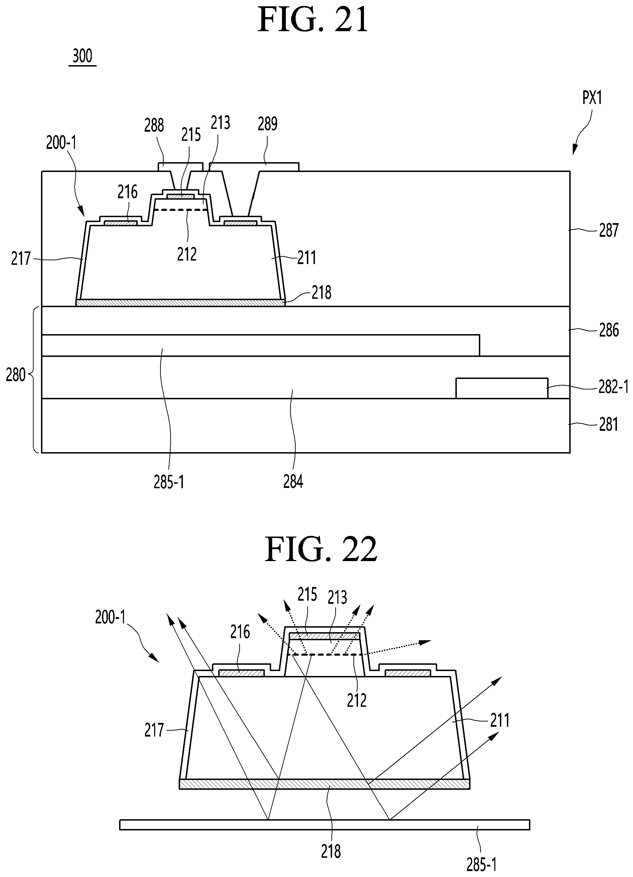

According to an embodiment, as illustrated in FIG. 22, a metal oxide layer 218 may be provided on the lower side of a semiconductor light-emitting element 200-1, a thickness t2 of the metal oxide layer 218 may be made smaller than a thickness t1 of a passivation layer 217, and a reflecting plate 285-1 may be provided under the semiconductor light-emitting element 200-1 on a backplane substrate. By a display device having such a structure, at least 80% (based on a red wavelength band) or 85% (based on a green wavelength band or a blue wavelength band) of light traveling downward from the semiconductor light-emitting element 200-1 may be reflected forward, so that light luminance can be improved.

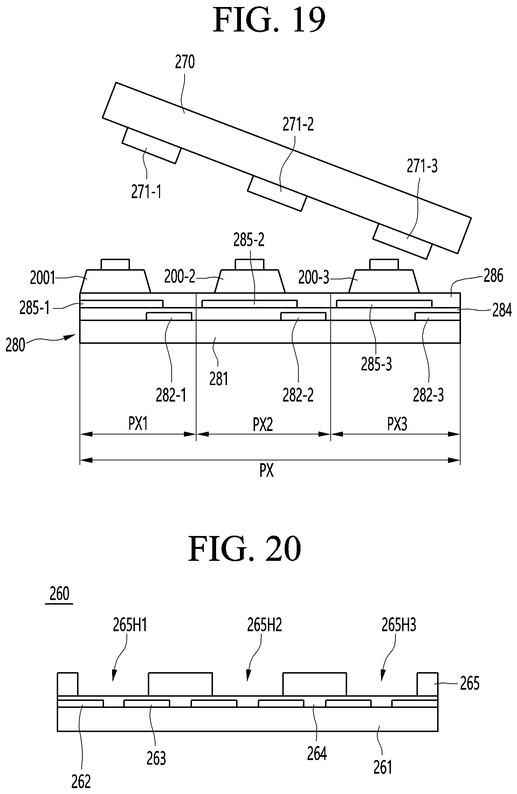

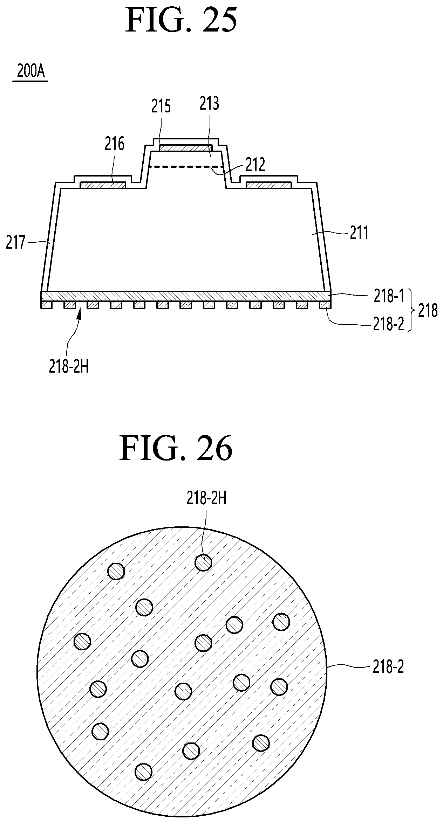

According to an embodiment, as illustrated in FIGS. 25 to 28, the metal oxide layer 218 may comprise a conductive oxide layer 218-1 and a dielectric oxide layer 218-2. In this instance, when the conductive oxide layer 218-1 or the dielectric oxide layer 218-2 is positioned at the lowest layer, some of the light that has traveled downward from an active layer 212 of the semiconductor light-emitting element 200A and 200B may be diffusely reflected and travel forward by a plurality of grooves 218-1H and 218-2H provided at the lowest layer, and the other light may travel downward from the semiconductor light-emitting element 200A and 200B and may be reflected forward by the reflecting plates 285-1 to 285-3 provided on the backplane substrate (280 of FIG. 19). Accordingly, the light extraction efficiency can be further increased, and the light luminance can be dramatically improved.

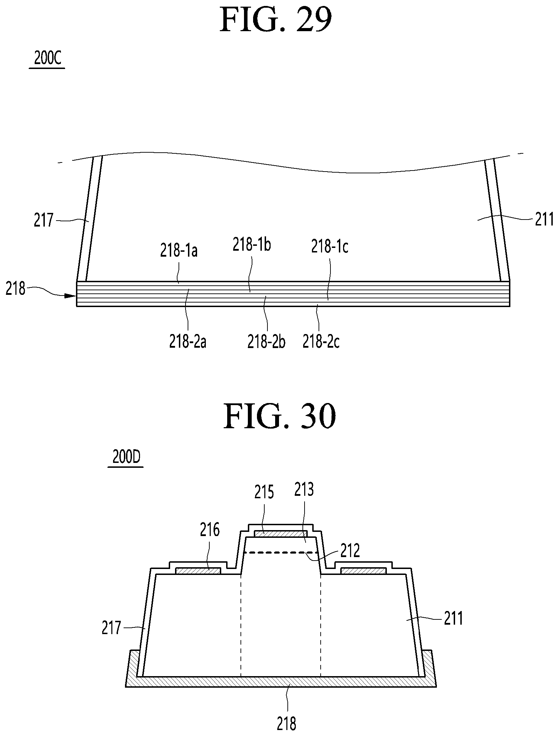

According to an embodiment, as illustrated in FIG. 29, the metal oxide layer 218 may be used as a reflective layer by laminating a plurality of first metal oxide layers 218-1a to 218-1c and a plurality of second metal oxide layers 218-2a to 218-2c having different refractive indices. In this instance, the first metal oxide layers 218-1a to 218-1c and the second metal oxide layers 218-2a to 218-2c are not made of pure metal and have strong binding strength with the epi layer, so that a peeling problem does not occur, and thus defect in the semiconductor light-emitting element 200C itself or defect in a product such as a display device can be prevented.

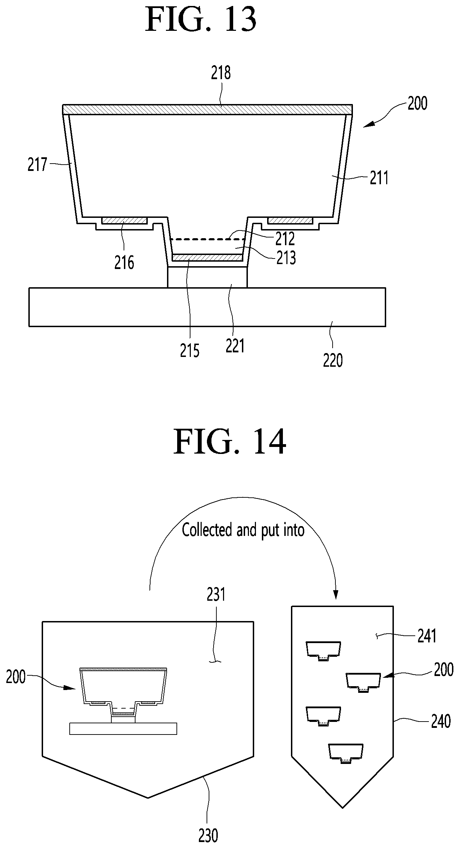

According to the embodiment, as illustrated in FIG. 30, the metal oxide layer 218 may be disposed on the passivation layer 217 along the perimeter of a lateral part of the light-emitting layer 211 to 213, so that the light-emitting layer 211 to 213 (or the epi layer) can be prevented from being damaged by the penetration of an etchant 231, as illustrated in FIG. 14. Accordingly, the emission failure of the semiconductor light-emitting element 200D can be prevented.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 illustrates a state in which a metal reflective layer is peeled off in a semiconductor light-emitting element according to a non-public internal technology.
FIG. 2 illustrates a living room of a house in which a display device according to an embodiment is disposed.
FIG. 3 is a block diagram schematically showing a display device according to an embodiment.
FIG. 4 is a circuit diagram showing an example of a pixel of FIG. 3.
FIG. 5 is an enlarged view of a first panel region in the display device of FIG. 2.
FIG. 6 illustrates a manufacturing process of a display device according to an embodiment.
FIG. 7 illustrates a plurality of semiconductor light-emitting elements manufactured at a wafer level.
FIG. 8 is a cross-sectional view illustrating a semiconductor light-emitting element according to a first embodiment.
FIG. 9 is a plan view illustrating a first electrode and a second electrode in a semiconductor light-emitting element according to the first embodiment.
FIGS. 10 to 14 illustrate a manufacturing process of a semiconductor light-emitting element according to the first embodiment.
FIG. 15 illustrates a process of assembling a plurality of semiconductor light-emitting elements on an interposer by performing a self-assembly process.
FIG. 16 shows the assembly rate by voltage in each of the comparative example, the embodiment 1, and the embodiment 2.
FIGS. 17 to 19 illustrate a process of transferring a plurality of semiconductor light-emitting elements onto a backplane substrate using a pick-and-place process.
FIG. 20 is a cross-sectional view illustrating an interposer according to an embodiment.
FIG. 21 is a cross-sectional view illustrating a display device according to an embodiment.
FIG. 22 illustrates the improvement of light luminance using a reflecting plate and a metal oxide layer of a semiconductor light-emitting element in a display device according to an embodiment.
FIG. 23 shows the light reflectance in the red wavelength band in each of the embodiments 1 and 2.
FIG. 24 shows the light reflectance in the green wavelength band and the blue wavelength band in each of the embodiments 1 and 2.
FIG. 25 is a cross-sectional view illustrating a semiconductor light-emitting element according to a second embodiment.
FIG. 26 is a plan view illustrating a dielectric oxide layer in a semiconductor light-emitting element according to the second embodiment.
FIG. 27 is a cross-sectional view illustrating a semiconductor light-emitting element according to a third embodiment.
FIG. 28 is a plan view illustrating a conductive oxide layer in a semiconductor light-emitting element according to the third embodiment.
FIG. 29 is a cross-sectional view illustrating a semiconductor light-emitting element according to a fourth embodiment.
FIG. 30 is a cross-sectional view illustrating a semiconductor light-emitting element according to a fifth embodiment.
FIG. 31 is a cross-sectional view illustrating a semiconductor light-emitting element according to a sixth embodiment.

The sizes, shapes, dimensions, etc. of elements illustrated in the drawings may differ from actual ones. In addition, even if the same elements are illustrated in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

The display device described in this specification may comprise a TV, a signage, a mobile terminal such as a mobile phone or a smart phone, a computer display such as a laptop or a desktop, a head-up display (HUD) for an automobile, a backlight unit for a display, a display for VR, AR or mixed reality (MR), a light source, etc. However, the configuration according to the embodiment described in this specification may be equally applied to a device capable of displaying, even if it is a new product type developed in the future.

FIG. 2 illustrates a living room of a house in which a display device according to an embodiment is disposed.

Referring to FIG. 2, the display device 100 according to the embodiment may display the status of various electronic products such as a washing machine 101, a robot vacuum cleaner 102, an air purifier 103, etc., and may communicate with each electronic product based on IoT and control each electronic product based on user setting data.

The display device 100 according to the embodiment may comprise a flexible display manufactured on a thin and flexible substrate. The flexible display may be bent or rolled like paper while maintaining the characteristics of a conventional flat display.

In a flexible display, visual information may be implemented by independently controlling the light emission of unit pixels disposed in a matrix form. A unit pixel means a minimum unit for implementing one color. The unit pixel of the flexible display may be implemented by a light-emitting element. In an embodiment, the light-emitting element may be a micro-LED or a nano-LED, but is not limited thereto.

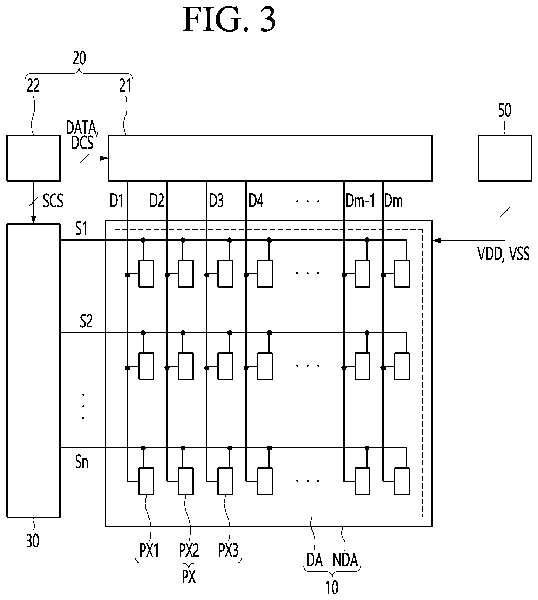

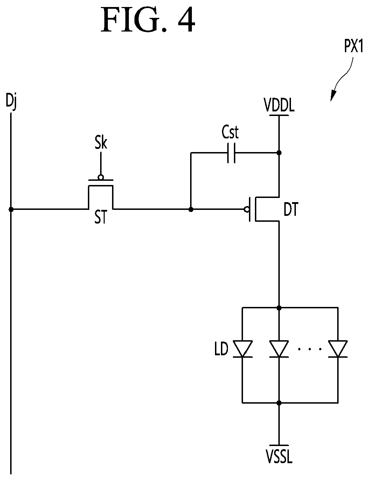

FIG. 3 is a block diagram schematically showing a display device according to an embodiment, and FIG. 4 is a circuit diagram showing an example of a pixel of FIG. 3.

Referring to FIG. 3 and FIG. 4, a display device according to an embodiment may comprise a display panel 10, a driving circuit 20, a scan driving unit 30, and a power supply circuit 50.

The display device 100 of the embodiment may drive the light-emitting element in an active matrix (AM) manner or a passive matrix (PM) manner.

The driving circuit 20 may comprise a data driving unit 21 and a timing control unit 22.

The display panel 10 may be formed in a rectangular shape, but is not limited thereto. That is, the display panel 10 may be formed in a circular or oval shape. At least one side of the display panel 10 may be formed to be bent at a predetermined curvature.

The display panel may comprise a display region DA. The display region DA is a region where pixels PX are formed to display an image. The display panel may comprise a non-display region NDA. The non-display region NDA may be a region excluding the display region DA.

As an example, the display region DA and the non-display region NDA may be defined on the same surface. For example, the non-display region NDA may surround the display region DA on the same surface together with the display region DA, but is not limited thereto.

As another example, although not illustrated in the drawing, the display region DA and the non-display region NDA may be defined on different surfaces. For example, the display region DA may be defined on the upper surface of the substrate, and the non-display region NDA may be defined on the lower surface of the substrate. For example, the non-display region NDA may be defined on the entire area or a part of the lower surface of the substrate.

Meanwhile, although the drawing illustrates that it is divided into a display region DA and a non-display region NDA, it may not be divided into a display region DA and a non-display region NDA. In other words, only a display region DA may exist on the upper surface of the substrate, and a non-display region NDA may not exist. In other words, the entire area of the upper surface of the substrate may be a display region DA where an image is displayed, and a bezel area, which is a non-display region NDA, may not exist.

The display panel 10 may comprise data lines (D1 to Dm, where m is an integer greater than or equal to 2), scan lines (S1 to Sn, where n is an integer greater than or equal to 2) intersecting the data lines D1 to Dm, a high-potential voltage line VDDL supplied with a high-potential voltage VDD, a low-potential voltage line VSSL supplied with a low-potential voltage VSS, and pixels PX connected to the data lines D1 to Dm and the scan lines S1 to Sn.

Each of the pixels PX may comprise a first subpixel PX1, a second subpixel PX2, and a third subpixel PX3. The first subpixel PX1 may emit a first color light of a first main wavelength, the second subpixel PX2 may emit a second color light of a second main wavelength, and the third subpixel PX3 may emit a third color light of a third main wavelength. The first color light may be red light, the second color light may be green light, and the third color light may be blue light, but is not limited thereto. In addition, although FIG. 3 exemplifies that each of the pixels PX comprises three subpixels, it is not limited thereto. That is, each of the pixels PX may comprise four or more subpixels.

Each of the first subpixel PX1, the second subpixel PX2, and the third subpixel PX3 may be connected to at least one of the data lines D1 to Dm, at least one of the scan lines S1 to Sn, and a high-potential voltage line VDDL. The first subpixel PX1 may comprise light-emitting elements LD and a plurality of transistors for supplying current to the light-emitting elements LD, and at least one capacitor Cst, as illustrated in FIG. 4.

Although not illustrated in the drawing, each of the first subpixel PX1, the second subpixel PX2, and the third subpixel PX3 may comprise only one light-emitting element LD and at least one capacitor Cst.

Each of the light-emitting elements LD may be a semiconductor light-emitting diode comprising a first electrode, a plurality of conductivity type semiconductor layers, and a second electrode. Here, the first electrode may be an anode electrode, and the second electrode may be a cathode electrode, but is not limited thereto.

The light-emitting element LD may be one of a lateral-type light-emitting element, a flip-chip type light-emitting element, and a vertical-type light-emitting element.

The plurality of transistors may comprise a driving transistor DT for supplying current to the light-emitting elements LD, and a scan transistor ST for supplying a data voltage to a gate electrode of the driving transistor DT, as illustrated in FIG. 4. The driving transistor DT may comprise a gate electrode connected to the source electrode of the scan transistor ST, a source electrode connected to the high-potential voltage line VDDL to which the high-potential voltage VDD is applied, and a drain electrode connected to the first electrodes of the light-emitting elements LD. The scan transistor ST may comprise a gate electrode connected to the scan line (Sk, where k is an integer satisfying 1 ≤ k ≤ n), a source electrode connected to the gate electrode of the driving transistor DT, and a drain electrode connected to the data line (Dj, where j is an integer satisfying 1 ≤ j ≤ m).

A capacitor Cst is formed between the gate electrode and the source electrode of the driving transistor DT. The storage capacitor Cst charges the difference between the gate voltage and the source voltage of the driving transistor DT.

The driving transistor DT and the scan transistor ST may be formed as thin film transistors. In addition, although FIG. 4 has been described with a focus on the driving transistor DT and the scan transistor ST being formed as a P-type metal oxide semiconductor field effect transistor (MOSFET), the present invention is not limited thereto. The driving transistor DT and the scan transistor ST may be formed as N-type MOSFETs. In this instance, the positions of the source electrode and the drain electrode of each of the driving transistor DT and the scan transistor ST may be changed.

In addition, in FIG. 4, it is exemplified that each of the first subpixel PX1, the second subpixel PX2, and the third subpixel PX3 comprises 2T1C (2 Transistor - 1 capacitor) having one driving transistor DT, one scan transistor ST, and one capacitor Cst, but the present invention is not limited thereto. Each of the first subpixel PX1, the second subpixel PX2, and the third subpixel PX3 may comprise a plurality of scan transistors ST and a plurality of capacitors Cst.

Since the second subpixel PX2 and the third subpixel PX3 may be expressed by substantially the same circuit diagram as the first subpixel PX1, detailed descriptions thereof will be omitted.

The driving circuit 20 outputs signals and voltages for driving the display panel 10. To this end, the driving circuit 20 may comprise a data driving unit 21 and a timing control unit 22.

The data driving unit 21 receives digital video data DATA and a source control signal DCS from the timing control unit 22. The data driving unit 21 converts digital video data DATA into analog data voltages according to the source control signal DCS and supplies the converted data to data lines D1 to Dm of the display panel 10.

The timing control unit 22 receives digital video data DATA and timing signals from a host system. The host system may be an application processor of a smartphone or tablet PC, a monitor, a system on chip of a TV, etc.

The timing control unit 22 generates control signals for controlling the operation timing of the data driving unit 21 and the scan driving unit 30. The control signals may comprise a source control signal DCS for controlling the operation timing of the data driving unit 21 and a scan control signal SCS for controlling the operation timing of the scan driving unit 30.

The driving circuit 20 may be disposed in a non-display region NDA provided on one side of the display panel 10. The driving circuit 20 may be formed as an integrated circuit (IC) and mounted on the display panel 10 in a chip on glass (COG) manner, a chip on plastic (COP) manner, or an ultrasonic bonding manner, but the present invention is not limited thereto. For example, the driving circuit 20 may be mounted on a circuit board (not illustrated) other than the display panel 10.

The data driving unit 21 may be mounted on the display panel 10 in a chip on glass (COG) manner, a chip on plastic (COP) manner, or an ultrasonic bonding manner, and the timing control unit 22 may be mounted on the circuit board.

The scan driving unit 30 receives a scan control signal SCS from the timing control unit 22. The scan driving unit 30 generates scan signals according to the scan control signal SCS and supplies them to scan lines S1 to Sn of the display panel 10. The scan driving unit 30 may be formed in the non-display region NDA of the display panel 10 comprising a plurality of transistors. Alternatively, the scan driving unit 30 may be formed as an integrated circuit, in which case it may be mounted on a gate flexible film attached to another side of the display panel 10.

The power supply circuit 50 may generate voltages required for driving the display panel 10 from the main power applied from the system board and supply them to the display panel 10. For example, the power supply circuit 50 may generate a high-potential voltage VDD and a low-potential voltage VSS for driving the light-emitting elements LD of the display panel 10 from the main power and supply them to the high-potential voltage line VDDL and the low-potential voltage line VSSL of the display panel 10. In addition, the power supply circuit 50 may generate and supply driving voltages for driving the driving circuit 20 and the scan driving unit 30 from the main power.

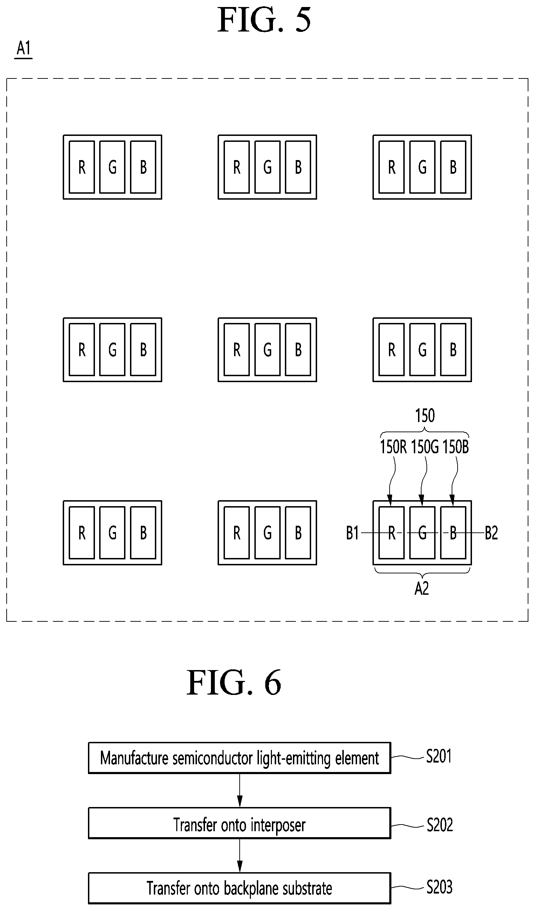

FIG. 5 is an enlarged view of a first panel region in the display device of FIG. 2.

Referring to FIG. 5, the display device 100 of the embodiment may be manufactured by mechanically and electrically connecting a plurality of panel regions such as the first panel region A1 by tiling.

The first panel region A1 may comprise a plurality of semiconductor light-emitting elements 150 disposed for each unit pixel (PX of FIG. 3).

Hereinafter, various embodiments for solving the above-described problem will be described with reference to FIGS. 6 to 31. Any description omitted below may be easily understood from the descriptions given above with respect to FIGS. 1 to 5 and the corresponding drawings.

The semiconductor light-emitting elements described below may have a size of micrometers or less.

In addition, the semiconductor light-emitting element described below may be a semiconductor light-emitting element in which the first electrode (anode electrode) and the second electrode (cathode electrode) are disposed toward the front. Accordingly, the semiconductor light-emitting element described below may mean a semiconductor light-emitting element.

FIG. 6 illustrates a manufacturing process of a display device according to an embodiment.

Referring to FIG. 6, the manufacturing process of the display device according to the embodiment may comprise a manufacturing process (S201) of a semiconductor light-emitting element, a transfer process (S202) onto an interposer, and a transfer process (S203) onto a backplane substrate.

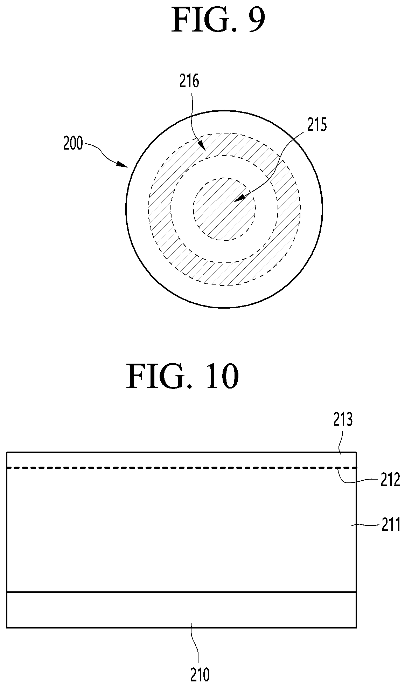

The manufacturing process (S201) of the semiconductor light-emitting element may be a process of manufacturing a large number of semiconductor light-emitting elements using a wafer level process based on a wafer. For example, as illustrated in FIG. 7, a large number of red semiconductor light-emitting elements 200 may be manufactured using a first wafer level process based on a first wafer 201. Although not illustrated, a large number of green semiconductor light-emitting elements may be manufactured using a second wafer level process based on a second wafer. Although not illustrated, a large number of blue semiconductor light-emitting elements may be manufactured using a third wafer level process based on a third wafer. For example, the first wafer 201 may be a GaAs substrate, and the second wafer and/or the third wafer may be a sapphire substrate. Here, the wafer level process may mean the entire process in which the semiconductor light-emitting elements are transferred from the wafer onto a temporary substrate and the temporary substrate is removed. The manufacturing process (S201) of the semiconductor light-emitting element will be described in detail later with reference to FIGS. 10 to 14.

The transfer process (S202) onto the interposer may be a process in which a plurality of red semiconductor light-emitting elements, a plurality of green semiconductor light-emitting elements, and a plurality of blue semiconductor light-emitting elements are transferred onto the interposer using a self-assembly process.

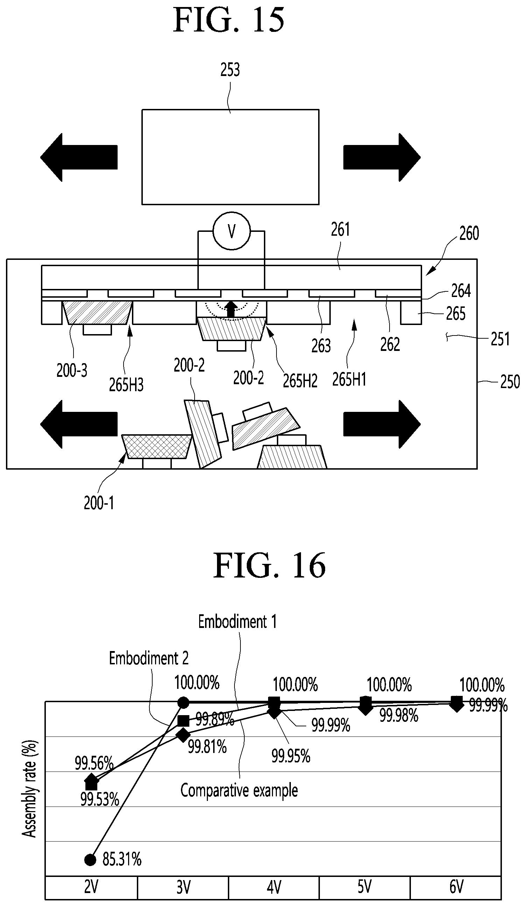

The transfer process (S203) onto the backplane substrate may be a process in which a plurality of red semiconductor light-emitting elements, a plurality of green semiconductor light-emitting elements, and a plurality of blue semiconductor light-emitting elements on the interposer are transferred onto the backplane substrate using a pick-and-place process. The transfer process (S202) onto the interposer and the transfer process (S203) onto the backplane substrate will be described in detail later with reference to FIGS. 15 to 19.

### [First embodiment]

FIG. 8 is a cross-sectional view illustrating a semiconductor light-emitting element according to a first embodiment.

FIG. 9 is a plan view illustrating a first electrode and a second electrode in a semiconductor light-emitting element according to the first embodiment.

Referring to FIGS. 8 and 9, the semiconductor light-emitting element 200 according to the first embodiment may comprise a light-emitting layer 211 to 213, a first electrode 215, a second electrode 216, a passivation layer 217, and a metal oxide layer 218.

The light-emitting layer 211 to 213 may emit light of a specific color. The specific color light may be determined by a semiconductor material of the light-emitting layer 211 to 213. The specific color light may be, for example, red light, green light, or blue light. For example, for the emission of red light, the light-emitting layer 211 to 213 may use a semiconductor material of the GaInAlP series. For the emission of green light or blue light, the light-emitting layer 211 to 213 may use a semiconductor material of the GaAlInN series.

The light-emitting layer 211 to 213 may comprise a plurality of semiconductor layers. For example, the light-emitting layer 211 to 213 may comprise at least one or more first conductivity type semiconductor layer 211, an active layer 212, and at least one or more second conductivity type semiconductor layer 213. The active layer 212 may be disposed on the first conductivity type semiconductor layer 211, and the second conductivity type semiconductor layer 213 may be disposed on the active layer 212. The first conductivity type semiconductor layer 211 may comprise an n-type dopant, and the second conductivity type semiconductor layer 213 may comprise a p-type dopant, but is not limited thereto.

The light-emitting layer 211 to 213 may have a first region 200a and a second region 200b surrounding the first region 200a.

The passivation layer 217 may be made of a material having excellent insulating property, so as to protect the light-emitting layer 211 to 213 and prevent leakage current flowing to the lateral part of the light-emitting layer 211 to 213. In addition, the passivation layer 217 may be properly assembled by causing a repulsive force to act against the DEP force during self-assembly so that the lower side of the semiconductor light-emitting element 200 may face a bottom surface of an assembly hole.

The passivation layer 217 may surround the lateral part of the light-emitting layer 211 to 213. The passivation layer 217 may be disposed on an upper side of the light-emitting layer 211 to 213. The passivation layer 217 may be disposed on the first electrode 215 and the second electrode 216 on the light-emitting layer 211 to 213.

The first electrode 215 and the second electrode 216 may be disposed on the upper side of the light-emitting layer 211 to 213. The first electrode 215 may be disposed on an upper side of the first region 200a of the light-emitting layer 211 to 213, and the second electrode 216 may be disposed on an upper side of the second region 200b of the light-emitting layer 211 to 213. The second electrode 216 may surround the first electrode 215. The second electrode 216 may be disposed along the perimeter of a lateral part of the first electrode 215. The first electrode 215 and the second electrode 216 may be spaced apart from each other.

The first electrode 215 and the second electrode 216 may be disposed on different layers. The first electrode 215 may be disposed on the second conductivity type semiconductor layer 213 of the light-emitting layer 211 to 213. The first electrode 215 may be in contact with an upper surface of the second conductivity type semiconductor layer 213, but is not limited thereto. The second electrode 216 may be disposed on the first conductivity type semiconductor layer 211 of the light-emitting layer 211 to 213. The second electrode 216 may be in contact with an upper surface of the first conductivity type semiconductor layer 211, but is not limited thereto.

The first electrode 215 and the second electrode 216 may be positioned at different heights. The second conductivity type semiconductor layer 213 may be positioned on the active layer 212, and the active layer 212 may be positioned on the first conductivity type semiconductor layer 211, so that the first electrode 215 on the second conductivity type semiconductor layer 213 may be positioned higher than the sum of the thickness of the active layer and the thickness of the second conductivity type semiconductor layer 213 compared to the second electrode 216 on the first conductivity type semiconductor layer 211.

As an example, the first electrode 215 and the second electrode 216 may be formed of a metal. The first electrode 215 and the second electrode 216 may be formed of different metals. Each of the first electrode 215 and the second electrode 216 may have a multilayer structure. The multilayer structure may comprise a magnetic layer, but is not limited thereto.

As another example, the first electrode 215 and the second electrode 216 may be made of a transparent conductive material. For example, the first electrode 215 and the second electrode 216 may be made of ITO, etc.

Meanwhile, as described above, according to the non-public internal technology, in order to compensate for the decrease in light luminance in a lateral-type semiconductor light-emitting element having a size of micrometers or less, a reflective layer made of metal was disposed on the lower side of the lateral-type semiconductor light-emitting element. However, the assembly rate was reduced due to the absorption of the lateral-type semiconductor light-emitting element by the metal during self-assembly. In addition, the reflective layer was peeled off due to the weakening of the binding force between the epilayer and the reflective layer of the lateral-type semiconductor light-emitting element.

In addition, according to the non-public internal technology, in order to increase the response speed by the magnet during self-assembly, a metal layer such as titanium (Ti) was provided on the lower side of the lateral-type semiconductor light-emitting element. However, the metal layer such as titanium (Ti) has excellent light absorption ability, so that the light reflectivity was reduced.

Meanwhile, in order for the lateral-type semiconductor light-emitting element to be easily assembled in the correct position by the DEP force during self-assembly, the area or arrangement position of the passivation layer 217 having a permittivity in the lateral-type semiconductor light-emitting element, as well as the area or arrangement position of the metal, are very important. Therefore, when the reflection layer is not provided to solve the above-described problem, the movement control for the lateral-type semiconductor light-emitting element may be unstable due to the DEP force, making it difficult to assemble in the correct position. For example, the lateral-type semiconductor light-emitting element may be assembled upside down, and in this case, electrical connection by the post-process is impossible, resulting in poor lighting.

According to an embodiment, in order to solve all of the above-described problems, a metal oxide layer 218 may be provided on the lower side of the semiconductor light-emitting element 200.

The metal oxide layer 218 may be disposed on the lower side of the light-emitting layer 211 to 213. The metal oxide layer 218 may be disposed under the first region 200a of the light-emitting layer 211 to 213. The metal oxide layer 218 may be disposed under the second region 200b of the light-emitting layer 211 to 213. The metal oxide layer 218 may be positioned on the same horizontal line. The metal oxide layer 218 may be in contact with a lower surface of the first conductivity type semiconductor layer 211, but is not limited thereto.

The metal oxide layer 218 may have conductivity or dielectric (or insulating) property depending on its type. That is, the metal oxide layer 218 may have conductivity or dielectric property depending on the type, number, and/or mixing ratio of metals combined with the oxide.

For example, the conductive oxide layer 218-1 may comprise ITO, SnO, AZO (ZnO:Al), BZO (ZnO:B), etc. For example, the dielectric oxide layer 218-2 may comprise SiO₂, TiO₂, Al₂O₃, HfO, etc.

In an embodiment, the metal oxide layer 218 may be made of a transparent material. That is, most of the light that passes from the active layer 212 to the metal oxide layer 218 may be transmitted.

Meanwhile, when the metal oxide layer 218 becomes thick, the light transmittance may decrease. In addition, the metal oxide layer 218 may also affect the relationship with the DEP force during self-assembly, such as attractive or repulsive force.
For example, when the metal oxide becomes thick, a repulsive force may be applied to the lateral-type semiconductor light-emitting element against the DEP force during self-assembly, so that the semiconductor light-emitting element 200 may not be assembled at a specific position and may be detached.

To solve this problem, the thickness t2 of the metal oxide layer 218 of the embodiment may be smaller than the thickness t1 of the passivation layer 217. For example, the thickness t2 of the metal oxide layer 218 may be 1/3 or less of the thickness t1 of the passivation layer 217. Preferably, the thickness t2 of the metal oxide layer 218 may be 1/10 or less of the thickness t1 of the passivation layer 217. Preferably, the thickness t2 of the metal oxide layer 218 may be 1/50 or less of the thickness t1 of the passivation layer 217. For example, when the thickness t1 of the passivation layer 217 is 500 nm, the thickness t2 of the metal oxide layer 218 may be 10 nm or less.

According to an embodiment, the thickness t2 of the metal oxide layer 218 may be smaller than the thickness t1 of the passivation layer 217, so that the lower side of the semiconductor light-emitting element 200 may be subject to an attractive force rather than a repulsive force by the DEP force during self-assembly, and the upper side of the semiconductor light-emitting element 200 may be subject to a repulsive force rather than an attractive force. Accordingly, the lateral-type semiconductor light-emitting element may be properly assembled without being flipped over during self-assembly, so that lighting defect can be prevented.

As illustrated in FIG. 22, a reflecting plate 285-1 may be provided on a backplane substrate, and a semiconductor light-emitting element 200-1 may be assembled on the backplane substrate, so that a display device may be manufactured.

Thereafter, when the display device is driven and light is emitted from the semiconductor light-emitting element 200-1, the light may travel in all directions. Among the emitted light, light that travels downward may pass through the metal oxide layer 218 and travel to the reflecting plate 285-1 to 285-3, and may be reflected by the reflecting plate 285-1 to 285-3 and travel forward via the semiconductor light-emitting element 200-1.

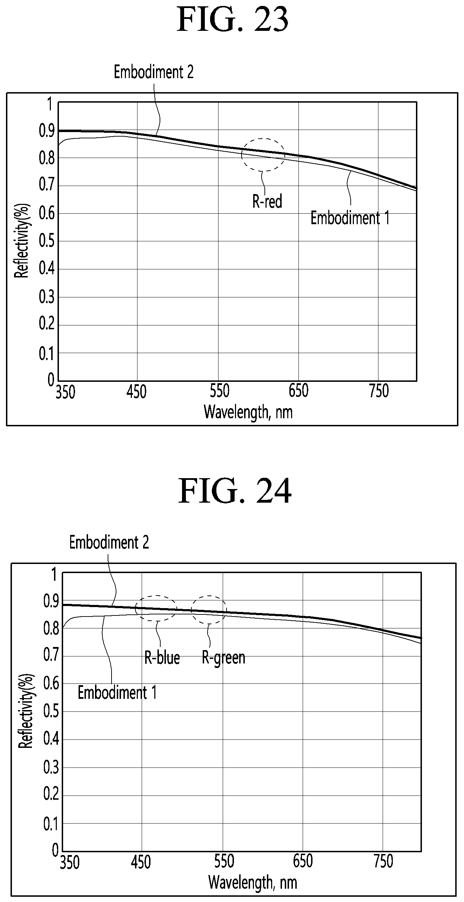

As described above, when a metal oxide layer 218 is provided on the lower side of the semiconductor light-emitting element 200-1, and the reflecting plates 285-1 to 285-3 are provided under the semiconductor light-emitting element 200-1, it may be seen that very high light reflectance may be implemented, as illustrated in FIGS. 23 and 24.

FIG. 23 illustrates a case where the semiconductor light-emitting element is a red lateral-type semiconductor light-emitting element 200-1, and FIG. 24 illustrates a case where the semiconductor light-emitting element is a green lateral-type semiconductor light-emitting element 200-2 or a blue semiconductor light-emitting element 200-3. In FIGS. 23 and 24, in the embodiment 1, 10 nm of TiO₂ may be used as the metal oxide layer 218, and in the embodiment 2, 10 nm of SiO₂ may be used as the metal oxide layer 218.

As illustrated in FIG. 23, a light reflectance capable of reflecting at least 80% of light in a red wavelength band of 616 nm or less forward was obtained.

As illustrated in FIG. 24, a light reflectance capable of reflecting at least 85% of light in a green wavelength band of 530 nm or less or light in a blue wavelength band of 463 nm or less forward was obtained.

Hereinafter, the manufacturing process (S201) of the semiconductor light-emitting element illustrated in FIG. 6 will be described in detail with reference to FIGS. 10 to 14.

FIGS. 10 to 14 illustrate a manufacturing process of a semiconductor light-emitting element according to the first embodiment.

As illustrated in FIG. 10, the light-emitting layer 211 to 213 comprising a plurality of semiconductor layers may be deposited on a growth substrate 210. The plurality of semiconductor layers may comprise at least one or more first conductivity type semiconductor layer 211, an active layer 212 on the first conductivity type semiconductor layer 211, and at least one or more second conductivity type semiconductor layer 213 on the active layer 212.

The growth substrate 210 may vary depending on the manufacturing of a red semiconductor light-emitting element, a green lateral-type semiconductor light-emitting element, or a blue semiconductor light-emitting element. For example, when manufacturing a red semiconductor light-emitting element, a GaAs substrate may be used as the growth substrate 210. For example, when manufacturing a green semiconductor light-emitting element or a blue semiconductor light-emitting element, a sapphire substrate may be used as the growth substrate 210.

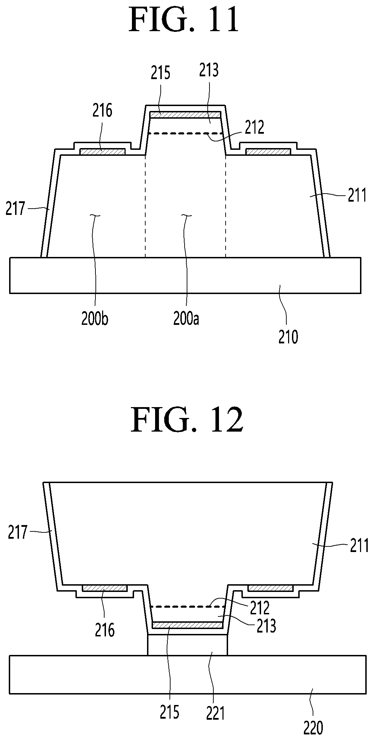

As illustrated in FIG. 11, by performing a mesh etching process, chips, i.e., the light-emitting layers 211 to 213, on the growth substrate 210 are separated from each other, and the second region 200b of each of the light-emitting layers 211 to 213 may also be etched so that the upper surface of the first conductive semiconductor layer 211 may be exposed.

Thereafter, a metal film may be deposited and patterned on the light-emitting layer 211 to 213, so that the first electrode 215 may be formed on the upper side of the first region 200a of the light-emitting layer 211 to 213, and the second electrode 216 may be formed on the upper side of the second region 200b of the light-emitting layer 211 to 213.

As an example, the first electrode 215 and the second electrode 216 may be formed simultaneously using the same photolithography process with the same metal.

As another example, the first electrode 215 and the second electrode 216 may be formed using separate photolithography processes with different metals from each other.

Thereafter, a passivation layer 217 may be formed on the light-emitting layer 211 to 213. After an insulating film is deposited on the growth substrate 210, the insulating film on the growth substrate 210 corresponding to the regions between the light-emitting layers 211 to 213 may be removed, thereby forming the passivation layer 217 on the light-emitting layer 211 to 213. The passivation layer 217 may surround a lateral part of the light-emitting layer 211 to 213 and may be formed on the upper side of the light-emitting layer 211 to 213.

As illustrated in FIG. 12, the light-emitting layer 211 to 213 may be flipped over and then bonded to a temporary substrate 220 via a sacrificial layer 221. Although not illustrated, an organic film such as a polymer may be provided between the sacrificial layer 221 and the temporary substrate 220. Thereafter, the light-emitting layer 211 to 213 may be transferred onto the temporary substrate 220 by removing the growth substrate 210 using an LLO process.

As illustrated in FIG. 13, a metal oxide layer 218 may be formed on the upper side of the light-emitting layer 211 to 213 exposed by removing the growth substrate 210. For example, the metal oxide layer 218 may be deposited on the upper side of the light-emitting layer 211 to 213 using deposition equipment such as PECVD, sputtering, ALD, or e-beam. Accordingly, a semiconductor light-emitting element 200 having a first electrode 215, a second electrode 216, a passivation layer 217, and a metal oxide layer 218 on light-emitting layer 211 to 213 may be manufactured.

As illustrated in FIG. 14, an etchant 231 may be contained in a first container 230, and a semiconductor light-emitting element 200 may be put into the first container 230, so that the sacrificial layer 221 may be removed and the semiconductor light-emitting element 200 may be separated from the temporary substrate.

Thereafter, the semiconductor light-emitting element 200 may be collected from the first container 230 and put into a second container 240. A deionized water (DI) may be contained in the second container 240. Accordingly, the semiconductor light-emitting element 200 may be cleaned by the deionized water (DI) in the second container 240. Thereafter, after the semiconductor light-emitting element 200 is collected from the second container 240, a drying process may be performed.

Hereinafter, the transfer process (S202) onto the interposer illustrated in FIG. 6 will be described in detail with reference to FIG. 15.

FIG. 15 illustrates a process of assembling a plurality of semiconductor light-emitting elements on an interposer by performing a self-assembly process.

As illustrated in FIG. 15, a fluid 251 may be filled in a chamber 250, and an interposer 260 may be mounted on an upper side of the chamber 250. Thereafter, a plurality of lateral-type semiconductor light-emitting elements 200-1 to 200-3 may be dropped into the chamber 250.

The interposer 260 may comprise a substrate 261, a first assembly wiring 262, a second assembly wiring 263, an insulating layer 264, and a partition wall 265, as illustrated in FIG. 20.

The substrate 261 may be a support substrate for supporting the first assembly wiring 262, the second assembly wiring 263, the insulating layer 264, and the partition wall 265.

The first assembly wiring 262 may be disposed on the substrate 261. The second assembly wiring 263 may be disposed on the substrate 261.

For example, the first assembly wiring 262 and the second assembly wiring 263 may be disposed on the same layer, respectively. For example, the first and second assembly wirings 262 and 263 may be in contact with an upper surface of the substrate 261, but are not limited thereto. For example, the first assembly wiring 262 and the second assembly wiring 263 may be disposed on the same layer, respectively. For example, the first assembly wiring 262 and the second assembly wiring 263 may be disposed parallel to each other, respectively. The first assembly wiring 262 and the second assembly wiring 263 may each serve to assemble the semiconductor light-emitting elements 200-1 to 200-3 into the assembly holes 265H1 to 265H3 using the self-assembly method. That is, when self-assembling, an electric field is generated between the first assembly wiring 262 and the second assembly wiring 263 by the voltage supplied to the first assembly wiring 262 and the second assembly wiring 263, and the semiconductor light-emitting elements 200-1 to 200-3, which are moving by the magnet, may be assembled into the assembly holes 265H1 to 265H3 by the DEP force formed by the electric field. The assembly holes 265H1 to 265H3 may have a diameter greater than the diameters of the semiconductor light-emitting elements 200-1 to 200-3, respectively.

The first assembly wiring 262 and the second assembly wiring 263 may each comprise a plurality of metal layers. Although not illustrated, the first assembly wiring 262 and the second assembly wiring 263 may each comprise a main wiring and an auxiliary electrode. The main wiring of each of the first assembly wiring 262 and the second assembly wiring 263 may be disposed long along one direction of the substrate 261. The auxiliary electrode of each of the first assembly wiring 262 and the second assembly wiring 263 may extend from the main wiring toward the assembly holes 265H1 to 265H3. The auxiliary electrode may be electrically connected to the main wiring. The main wiring may be disposed on the auxiliary wiring so that the lower surface of the main wiring may be in contact with the upper surface of the auxiliary wiring, but is not limited thereto.

Meanwhile, although not illustrated, the first assembly wiring 262 and the second assembly wiring 263 may be disposed on different layers.

The insulating layer 264 may be disposed on the first assembly wiring 262 and the second assembly wiring 263. For example, the insulating layer 264 may be formed of an inorganic material or an organic material. For example, the insulating layer 264 may be formed of a material having a permittivity related to the DEP force. For example, the higher the permittivity of the insulating layer 264, the greater the DEP force may be, but is not limited thereto. The insulating layer 264 may prevent the fluid from directly being in contact with the first assembly wiring 262 or the second assembly wiring 263 and causing corrosion during self-assembly by the assembly holes 265H1 to 265H3 of the partition wall 265 formed thereafter.

The partition wall 265 may be disposed on the insulating layer 264. The insulating layer 264 may have the assembly holes 265H1 to 265H3. The assembly holes 265H1 to 265H3 may be formed in the plurality of subpixels PX1, PX2, and PX3 of the plurality of pixels PX, respectively. That is, the assembly holes 265H1 to 265H3 may be formed one per the subpixels PX1, PX2, and PX3, respectively, but are not limited thereto. For example, the insulating layer 264 may be exposed within the assembly holes 265H1 to 265H3. For example, a bottom surface 158-2 of the assembly holes 265H1 to 265H3 may be the upper surface of the insulating layer 264.

The height (or thickness) of the partition wall 265 may be determined by considering the thickness of the semiconductor light-emitting elements 200-1 to 200-3.

Referring again to FIG. 15, a plurality of semiconductor light-emitting elements 200-1 to 200-3 may be moved within the fluid 251 in response to the movement of the magnet 253. The magnet 253 may be rotated, zigzag-moved, or zigzag-moved together with the rotation. The magnetic layer included in the first electrode 215 and/or the second electrode 216 of the lateral-type semiconductor light-emitting element may be magnetized by the magnet 253, so that the semiconductor light-emitting elements 200-1 to 200-3 may be moved toward the magnet 253.

Meanwhile, a DEP force may be formed on the interposer 260. A DEP force may be formed by an AC voltage applied to the first assembly wiring 262 and the second assembly wiring 263 disposed in each of the assembly holes 265H1 to 265H3. The intensity of the DEP force may be very strong within the assembly holes 265H1 to 265H3 and may be very weak or zero outside the assembly holes.

A plurality of semiconductor light-emitting elements 200-1 to 200-3 moving by the magnet 253 may be pulled by the DEP force formed in the corresponding assembly holes 265H1 to 265H3 and assembled in the corresponding assembly holes 265H1 to 265H3.

As an example, a plurality of red semiconductor light-emitting elements 200-1, a plurality of green semiconductor light-emitting elements 200-2, and a plurality of blue semiconductor light-emitting elements 200-3 may be sequentially assembled into a plurality of subpixels PX1, PX2, and PX3 of each of a plurality of pixels PX on the substrate 261, respectively.

As another example, a plurality of red semiconductor light-emitting elements 200-1, a plurality of green semiconductor light-emitting elements 200-2, and a plurality of blue semiconductor light-emitting elements 200-3 may be simultaneously assembled into a plurality of subpixels PX1, PX2, and PX3 of each of a plurality of pixels PX on the substrate 261. To this end, a plurality of red semiconductor light-emitting elements 200-1, a plurality of green semiconductor light-emitting elements 200-2, and a plurality of blue semiconductor light-emitting elements 200-3 may be dropped into a fluid in a chamber 250 and mixed. Subsequently, the same self-assembly process may be performed so that a plurality of red semiconductor light-emitting elements 200-1, a plurality of green semiconductor light-emitting elements 200-2, and a plurality of blue semiconductor light-emitting elements 200-3 may be simultaneously assembled into a plurality of subpixels PX1, PX2, and PX3 of each of a plurality of pixels PX on the substrate 261.

For the simultaneous self-assembly, the red semiconductor light-emitting elements 200-1, the green semiconductor light-emitting elements 200-2, and the blue semiconductor light-emitting elements 200-3 may each have exclusivity with respect to each other. That is, the shapes or sizes of the red semiconductor light-emitting elements 200-1, the green semiconductor light-emitting elements 200-2, and the blue semiconductor light-emitting elements 200-3 may be different from each other. For example, the red semiconductor light-emitting element 200-1 may have a circular shape, the green semiconductor light-emitting element 200-2 may have a first oval shape having a first minor axis and a first major axis, and the blue semiconductor light-emitting element 200-3 may have a second oval shape. At this time, the second oval shape may have a second minor axis smaller than the first minor axis and a second major axis larger than the first major axis.

Meanwhile, as described above, according to the non-public internal technology, a metal layer such as titanium (Ti) was provided on the lower side of the lateral-type semiconductor light-emitting element in order to increase the response speed by the magnet during self-assembly, but the light reflectivity was reduced by the metal layer such as titanium (Ti).

According to the embodiment, as illustrated in FIG. 8, a metal oxide layer 218 may be disposed on the lower side of the semiconductor light-emitting element 200, and the thickness of the metal oxide layer 218 may be made smaller than the thickness of the passivation layer 217, so that the response speed by magnet 253 can be improved during self-assembly, and the assembly rate can be improved by receiving strong influence of DEP force, i.e., the attractive force.

FIG. 16 shows the assembly rates by voltage in each of the comparative example, embodiment 1, and embodiment 2.

In FIG. 16, the comparative example has a metal layer such as titanium (Ti) provided on the lower side of the semiconductor light-emitting element, and in embodiment 1, the metal oxide layer 218 disposed on the lower side of the semiconductor light-emitting element 200 may be made of TiO₂, and in embodiment 2, the metal oxide layer 218 disposed on the lower side of the semiconductor light-emitting element 200 may be made of SiO₂.

As illustrated in FIG. 16, when the AC voltage applied to the first assembly wiring 262 and the second assembly wiring 263 is 3 V or higher, the assembly rate may be higher than or equal to that of the comparative example in the embodiments 1 and 2. From this, it can be seen that even when the metal oxide layer 218 of the embodiments 1 and 2 is used instead of a metal layer such as Ti, a superior assembly rate is shown than that of the comparative example.

Meanwhile, according to the embodiment, as illustrated in FIG. 8, a metal oxide layer 218 may be disposed on the lower side of the semiconductor light-emitting element 200. Since the metal oxide layer 218 has hydrophilicity, the semiconductor light-emitting element 200 may not be adsorbed on the surface of the interposer 260 during self-assembly, so that the assembly rate can be improved.

Meanwhile, referring back to FIG. 15, after the self-assembly process is performed, a plurality of semiconductor light-emitting elements 200-1 to 200-3 are assembled on the interposer 260, the interposer 260 is detached from the chamber 250, and a drying process and a cleaning process are performed, the interposer 260 may be dried and cleaned.

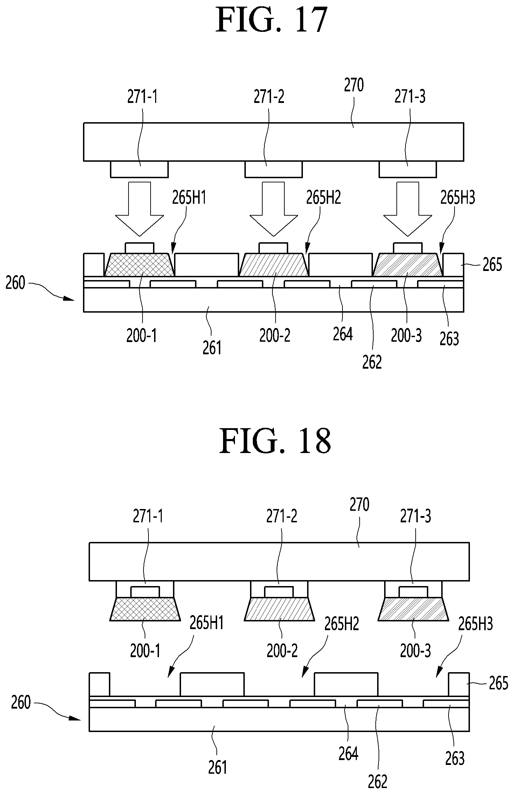

Hereinafter, the transfer process (S203) onto the backplane substrate illustrated in FIG. 6 will be described in detail with reference to FIGS. 17 to 19.

FIGS. 17 to 19 illustrate a process of transferring a plurality of semiconductor light-emitting elements onto a backplane substrate using a pick-and-place process.

As illustrated in FIG. 17, when the interposer 260 is moved from the outside onto a stage (not illustrated), a stamp 270 may be lowered and pressurized so that the plurality of lateral-type semiconductor light-emitting elements 200-1 to 200-3 on the interposer 260 may be attached to the protruding regions 271-1 to 271-3 of the stamp 270. At this time, the adhesive force of the lower surface of each of the protruding regions 271-1 to 271-3 may be greater than the adhesive force of the interposer 260 on which the plurality of semiconductor light-emitting elements 200-1 to 200-3 are assembled.

The plurality of protruding regions 271-1 to 271-3 of the stamp 270 may be positioned to correspond to the plurality of semiconductor light-emitting elements 200-1 to 200-3 on the interposer 260, respectively. A plurality of semiconductor light-emitting elements 200-1 to 200-3 may be attached to the plurality of protruding regions 271-1 to 271-3 of the stamp 270 as many as the number of protruding regions 271-1 to 271-3 of the stamp 270.

As illustrated in FIG. 18, the stamp 270 may be raised. At this time, a plurality of semiconductor light-emitting elements 200-1 to 200-3 may be attached to each of the plurality of protruding regions 271-1 to 271-3 of the raised stamp 270.

As illustrated in FIG. 19, the stamp 270 may be moved and positioned on a backplane substrate 280.

The backplane substrate 280 may comprise a plurality of pixels PX, and each of the plurality of pixels PX may comprise a plurality of subpixels PX1 to PX3.

A plurality of pixel driving units 282-1 to 282-3, a first insulating layer 284, a plurality of reflecting plates 285-1 to 285-3, and a second insulating layer 286 may be disposed on a substrate 281. The pixel driving units 282-1 to 282-3 may be provided in a plurality of subpixels PX1 to PX3 to operate the light emission of the corresponding semiconductor light-emitting elements 200-1 to 200-3, but is not limited thereto.

A plurality of reflecting plates 285-1 to 285-3 may be provided in a plurality of subpixels PX1 to PX3, respectively. The reflecting plate 285-1 to 285-3 may be made of metal, but is not limited thereto. In the drawing, the plurality of reflecting plates 285-1 to 285-3 are separated from each other, but they may be formed integrally with each other. The plurality of reflecting plates 285-1 to 285-3 may be disposed under the corresponding semiconductor light-emitting elements 200-1 to 200-3, respectively, so as to reflect light from the semiconductor light-emitting elements 200-1 to 200-3 forward.

The first insulating layer 284 and/or the second insulating layer 286 may be made of different insulating materials, but are not limited thereto.

The second insulating layer 286 may be an adhesive layer. The second insulating layer 286 may transfer the plurality of semiconductor light-emitting elements 200-1 to 200-3 on the stamp 270 to the backplane substrate 280. That is, the stamp 270 may be lowered, pressurized, and then raised again, so that the plurality of semiconductor light-emitting elements 200-1 to 200-3 on the stamp 270 may be transferred onto the backplane substrate 280. At this time, since the adhesive force of the backplane substrate 280, i.e., the adhesive force of the second insulating layer 286, is greater than the adhesive force of the protruding regions 271-1 to 271-3, the plurality of semiconductor light-emitting elements 200-1 to 200-3 on the stamp 270 may be attached to the second insulating layer 286 of the backplane substrate 280, so that the plurality of semiconductor light-emitting elements 200-1 to 200-3 may be separated from the stamp 270.

Thereafter, electrical connection to the plurality of semiconductor light-emitting elements 200-1 to 200-3 may be made through a post-process. This will be described later with reference to FIG. 21.

FIG. 21 is a cross-sectional view illustrating a display device according to an embodiment. FIG. 21 illustrates the first subpixel PX1 among the first subpixel PX1 to the third subpixel PX3 on the backplane substrate 280 illustrated in FIG. 19. The second subpixel PX2 and the third subpixel PX3 may have the same structure as the structure of the first subpixel PX1 except that the semiconductor materials of the light-emitting layers 211 to 213 of the plurality of semiconductor light-emitting elements 200-1 to 200-3 are different.

Referring to FIG. 21, the display device 300 according to the embodiment may comprise a backplane substrate 280, a semiconductor light-emitting element 200-1, a third insulating layer 287, a first electrode wiring 288, and a second electrode wiring 289.

Although only a red lateral-type semiconductor light-emitting element 200-1 is illustrated in the drawing, a red semiconductor light-emitting element (200-1 of FIG. 19), a green semiconductor light-emitting element 200-2, and a blue semiconductor light-emitting element 200-3 may be disposed in a plurality of subpixels, respectively, of each of a plurality of pixels of the backplane substrate 280. Meanwhile, the green semiconductor light-emitting element 200-2 may be replaced with a green vertical-type semiconductor light-emitting element or a green flip-chip type semiconductor light-emitting element. **In** addition, the blue semiconductor light-emitting element 200-3 may be replaced with a blue vertical-type semiconductor light-emitting element or a blue flip-chip type semiconductor light-emitting element.

Since the semiconductor light-emitting elements 200-1 to 200-3 are transferred onto the backplane substrate 280 as described in detail in FIGS. 17 to 19, detailed descriptions thereof will be omitted.

After the semiconductor light-emitting elements 200-1 to 200-3 are transferred onto the backplane substrate 280 as described in FIGS. 17 to 19, a third insulating layer 287 may be formed. The third insulating layer 287 may be formed of an organic material, but is not limited thereto.

The third insulating layer 287 is a planarization layer, and its upper surface may have a straight plane. Since the upper surface of the third insulating layer 287 has a straight plane, the first electrode wiring 288 and the second electrode wiring 289 disposed on the third insulating layer 287 may be formed with a uniform thickness.

Although the drawing illustrates that the upper surface of the third insulating layer 287 is disposed on the upper side of the semiconductor light-emitting element 200-1, the upper surface of the third insulating layer 287 may not be disposed on the upper side of the semiconductor light-emitting element 200-1. That is, even if the third insulating layer 287 is disposed on the backplane substrate 280, the upper side of the semiconductor light-emitting element 200-1 may be exposed to the outside. For example, the upper surface of the third insulating layer 287 may be positioned on the same horizontal line as the upper surface of the semiconductor light-emitting element 200-1.

The first electrode wiring 288 and the second electrode wiring 289 may be disposed on the third insulating layer 287. The first electrode wiring 288 and the second electrode wiring 289 may be electrically insulated from each other by being spaced apart from each other. The first electrode wiring 288 and the second electrode wiring 289 may be formed simultaneously using the same photolithography process with the same material, but are not limited thereto. The first electrode wiring 288 and the second electrode wiring 289 may be formed of a transparent conductive material such as ITO. The first electrode wiring 288 and the second electrode wiring 289 may be formed of an opaque metal, but may be so thin that the light transmittance may be maintained at 80% or more.

The first electrode wiring 288 and the second electrode wiring 289 may be electrically connected to the first electrode 215 and the second electrode 216, respectively, of the semiconductor light-emitting element 200-1 through the third insulating layer 287. Although not illustrated, the first electrode wiring 288 and the second electrode wiring 289 may be electrically connected directly to the first electrode 215 and the second electrode 216, respectively, of the semiconductor light-emitting element 200-1 without passing through the third insulating layer 287. That is, since the third insulating layer 287 is not formed on the upper side of the semiconductor light-emitting element 200-1, the upper side of the semiconductor light-emitting element 200-1 may be exposed to the outside. In this instance, the first electrode wiring 288 and the second electrode wiring 289 may be electrically connected to the first electrode 215 and the second electrode 216, respectively, on the upper side of the semiconductor light-emitting element 200-1 through the passivation layer 217.

According to an embodiment, as illustrated in FIG. 8, a metal oxide layer 218 may be provided on the lower side of the semiconductor light-emitting element 200, and the thickness t2 of the metal oxide layer 218 may be made smaller than the thickness t1 of the passivation layer 217. Accordingly, during self-assembly, the lower side of the semiconductor light-emitting element 200 may be subjected to an attractive force rather than a repulsive force by the DEP force, and the upper side of the semiconductor light-emitting element 200 may be subjected to a repulsive force rather than an attractive force. Therefore, since the lateral-type semiconductor light-emitting element is properly assembled without being over during self-assembly, lighting failure can be prevented.

According to a non-public internal technology, when a reflective layer made of metal is disposed on the lower side of the lateral-type semiconductor light-emitting element, the lateral-type semiconductor light-emitting element is adsorbed on the backplane substrate by the reflective layer, and the assembly rate is reduced. According to an embodiment, a metal oxide layer 218 having hydrophilicity may be provided on the lower side of the semiconductor light-emitting element, so that the semiconductor light-emitting element 200-1 may be not adsorbed to the surface of the backplane substrate 280 by the metal oxide layer 218 during self-assembly, thereby improving the assembly rate.

According to a non-public internal technology, when a metal layer such as Ti is disposed on the lower side of the semiconductor light-emitting element to increase the response speed to a magnet during self-assembly, the metal layer absorbs most of the light traveling downward, and thus the light extraction efficiency is reduced. According to an embodiment, as illustrated in FIG. 8, a metal oxide layer 218 may be provided on the lower side of the semiconductor light-emitting element 200, and the thickness t2 of the metal oxide layer 218 may be made smaller than the thickness t1 of the passivation layer 217, so that light can be transmitted instead of absorbed.

According to an embodiment, as illustrated in FIG. 22, a metal oxide layer 218 may be provided on the lower side of a semiconductor light-emitting element 200-1, a thickness t2 of the metal oxide layer 218 may be made smaller than a thickness t1 of a passivation layer 217, and the reflecting plates 285-1 may be provided under the semiconductor light-emitting element 200-1 on a backplane substrate 280. By a display device having such a structure, at least 80% (based on a red wavelength band) or 85% (based on a green wavelength band or a blue wavelength band) of light traveling downward from the semiconductor light-emitting element 200-1 may be reflected forward, so that light luminance can be improved.

### [Second Embodiment]

FIG. 25 is a cross-sectional view illustrating a semiconductor light-emitting element according to a second embodiment. FIG. 26 is a plan view illustrating a dielectric oxide layer 218-2 in a semiconductor light-emitting element according to the second embodiment.

The second embodiment is the same as the first embodiment (FIG. 8) except for the metal oxide layer 218. In the second embodiment, components having the same shape, structure, and/or function as those in the first embodiment are given the same drawing reference numerals, and detailed descriptions thereof will be omitted.

Referring to FIGS. 25 and 26, the semiconductor light-emitting element 200A according to the second embodiment may comprise a light-emitting layer 211 to 213, a first electrode 215, a second electrode 216, a passivation layer 217, and a metal oxide layer 218. The semiconductor light-emitting element 200A according to the second embodiment may be a red lateral-type semiconductor light-emitting element, a green semiconductor light-emitting element, and/or a blue semiconductor light-emitting element.

In an embodiment, the metal oxide layer 218 may comprise a conductive oxide layer 218-1 and a dielectric oxide layer 218-2.

The conductive oxide layer 218-1 may be disposed under a lower side of the light-emitting layer 211 to 213. The conductive oxide layer 218-1 may be disposed on the lower side of the light-emitting layer 211 to 213. The conductive oxide layer 218-1 may be disposed on a lower side of the first conductivity type semiconductor layer 211. The conductive oxide layer 218-1 may be in contact with a lower surface of the first conductivity type semiconductor layer 211, but is not limited thereto. The conductive oxide layer 218-1 may have the same shape as the shape of a lower surface of the first conductivity type semiconductor layer 211. The conductive oxide layer 218-1 may have the same size (or area) as the lower surface of the first conductivity type semiconductor layer 211, but is not limited thereto. For example, the conductive oxide layer 218-1 may comprise ITO, SnO, AZO (ZnO:Al), BZO (ZnO:B), etc.

The dielectric oxide layer 218-2 may be disposed on the lower side of the conductive oxide layer 218-1. The dielectric oxide layer 218-2 may be in contact with the lower surface of the conductive oxide layer 218-1, but is not limited thereto. The dielectric oxide layer 218-2 may have the same shape as the shape of the lower surface of the conductive oxide layer 218-1. The dielectric oxide layer 218-2 may have the same size (or area) as the lower surface of the conductive oxide layer 218-1, but is not limited thereto. For example, the dielectric oxide layer 218-2 may comprise SiO₂, TiO₂, Al₂O₃, HfO, etc.

Meanwhile, the dielectric oxide layer 218-2 may have a plurality of grooves 218-2H. As illustrated in FIG. 26, the plurality of grooves 218-2H may have a circular shape, but is not limited thereto. The plurality of grooves 218-2H may be formed to penetrate the dielectric oxide layer 218-2 and expose a lower surface of the conductive oxide layer 218-1, but is not limited thereto. The thickness t2 of the dielectric oxide layer 218-2 is λ/4n, so that diffuse reflection of light can be enhanced.

According to the second embodiment, some of the light that has traveled downward from the active layer 212 of the light-emitting layer 211 to 213 may be diffusely reflected and travel forward by the plurality of grooves 218-2H provided in the dielectric oxide layer 218-2, and the other light may travel downward from the semiconductor light-emitting element 200A and may be reflected forward by the reflecting plates 285-1 to 285-3 provided on the backplane substrate. Accordingly, the light extraction efficiency can be further increased, and the light luminance can be dramatically improved.

### [Third Embodiment]

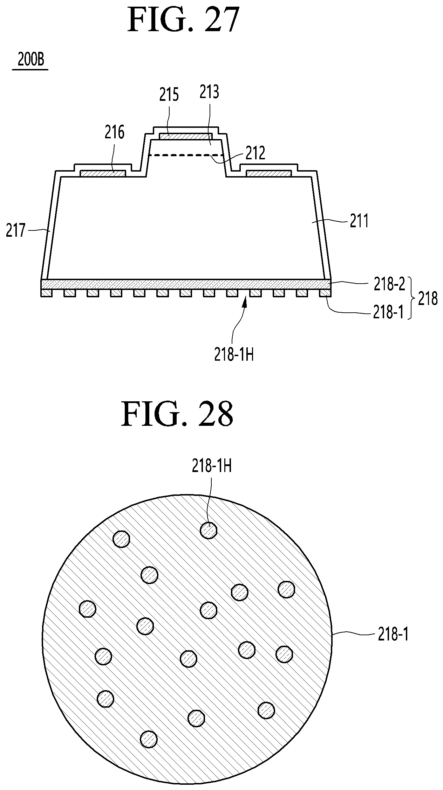

FIG. 27 is a cross-sectional view illustrating a semiconductor light-emitting element according to a third embodiment. FIG. 28 is a plan view illustrating a conductive oxide layer 218-1 in a semiconductor light-emitting element according to a third embodiment.

The third embodiment is the same as the first embodiment or the second embodiment except for the metal oxide layer 218. In particular, the third embodiment is the same as the second embodiment except for the arrangement order of the conductive oxide layer 218-1 and the dielectric oxide layer 218-2 of the metal oxide layer 218. In the third embodiment, components having the same shape, structure, and/or function as those in the first embodiment or the second embodiment are given the same drawing reference numerals, and detailed descriptions thereof will be omitted.

Referring to FIGS. 27 and 28, the semiconductor light-emitting element 200B according to the third embodiment may comprise a light-emitting layer 211 to 213, a first electrode 215, a second electrode 216, a passivation layer 217, and a metal oxide layer 218. The semiconductor light-emitting element 200B according to the third embodiment may be a red lateral-type semiconductor light-emitting element, a green semiconductor light-emitting element, and/or a blue semiconductor light-emitting element.

In the embodiment, the metal oxide layer 218 may comprise a dielectric oxide layer 218-2 and a conductive oxide layer 218-1.

The dielectric oxide layer 218-2 may be disposed under the light-emitting layer 211 to 213. The dielectric oxide layer 218-2 may be disposed on a lower side of the light-emitting layer 211 to 213. The dielectric oxide layer 218-2 may be disposed on a lower side of the first conductivity type semiconductor layer 211. The dielectric oxide layer 218-2 may be in contact with a lower surface of the first conductivity type semiconductor layer 211, but is not limited thereto. The dielectric oxide layer 218-2 may have the same shape as the shape of the lower surface of the first conductivity type semiconductor layer 211. The dielectric oxide layer 218-2 may have the same size (or area) as the lower surface of the first conductivity type semiconductor layer 211, but is not limited thereto. For example, the dielectric oxide layer 218-2 may comprise SiO₂, TiO₂, Al₂O₃, HfO, etc.

The conductive oxide layer 218-1 may be disposed under the lower side of the dielectric oxide layer 218-2. The conductive oxide layer 218-1 may be in contact with a lower surface of the dielectric oxide layer 218-2, but is not limited thereto. The conductive oxide layer 218-1 may have the same shape as the shape of the lower surface of the dielectric oxide layer 218-2. The conductive oxide layer 218-1 may have the same size (or area) as the lower surface of the dielectric oxide layer 218-2, but is not limited thereto. For example, the conductive oxide layer 218-1 may comprise ITO, SnO, AZO (ZnO:Al), BZO (ZnO:B), etc.

Meanwhile, the conductive oxide layer 218-1 may have a plurality of grooves 218-1H. As illustrated in FIG. 28, the plurality of grooves 218-1H may have a circular shape, but is not limited thereto. The plurality of grooves 218-1H may be formed to penetrate the conductive oxide layer 218-1 and expose the lower surface of the dielectric oxide layer 218-2, but is not limited thereto. The thickness t2 of the conductive oxide layer 218-1 is λ/4n, so that the diffuse reflection of light can be activated.

According to the third embodiment, some of the light that has traveled downward from the active layer 212 of the light-emitting layer 211 to 213 by the plurality of grooves 218-1H provided in the conductive oxide layer 218-1 may be diffused and travels forward, and the other light may travel downward from the semiconductor light-emitting element 200B and be reflected forward by the reflecting plates 285-1 to 285-3 provided on the backplane substrate. Accordingly, the light extraction efficiency can be further increased, and the light luminance can be dramatically improved.

### [Fourth Embodiment]

FIG. 29 is a cross-sectional view illustrating a semiconductor light-emitting element according to a fourth embodiment.

The fourth embodiment is the same as the first to third embodiments except for the metal oxide layer 218. In the fourth embodiment, components having the same shape, structure, and/or function as those in the first to third embodiments are given the same drawing reference numerals, and detailed descriptions thereof will be omitted.

Referring to FIG. 29, the semiconductor light-emitting element 200C according to the fourth embodiment may comprise a light-emitting layer 211 to 213, a first electrode 215, a second electrode 216, a passivation layer 217, and a metal oxide layer 218. The semiconductor light-emitting element 200C according to the fourth embodiment may be a red lateral-type semiconductor light-emitting element, a green semiconductor light-emitting element, and/or a blue semiconductor light-emitting element.

In an embodiment, the metal oxide layer 218 may comprise a plurality of first metal oxide layers 218-1a to 218-1c and a plurality of second metal oxide layers 218-2a to 218-2c. For example, the first metal oxide layers 218-1a to 218-1c and the second metal oxide layers 218-2a to 218-2c may be dielectric oxide layers. For example, the dielectric oxide layer may comprise SiO₂, TiO₂, Al₂O₃, HfO, etc. For example, the first metal oxide layers 218-1a to 218-1c and the second metal oxide layers 218-2a to 218-2c may have different refractive indices among the materials constituting the dielectric oxide layer. For example, the first metal oxide layers 218-1a to 218-1c may comprise SiO₂, and the second metal oxide layers 218-2a to 218-2c may comprise TiO₂, but are not limited thereto. For example, the metal oxide layers 218 may be configured as 5 to 30 pairs, with the first metal oxide layers 218-1a to 218-1c and the second metal oxide layers 218-2a to 218-2c as one pair.

The total thickness of the plurality of first metal oxide layers 218-1a to 218-1c or the total thickness of the plurality of second metal oxide layers 218-2a to 218-2c may be 1/5 or less of the thickness of the passivation layer 217. The sum of the total thickness of the plurality of first metal oxide layers 218-1a to 218-1c and the total thickness of the plurality of second metal oxide layers 218-2a to 218-2c may be less than or equal to 1/2 of the thickness of the passivation layer 217.

According to the fourth embodiment, the metal oxide layer 218 may be used as a reflective layer by laminating the plurality of first metal oxide layers 218-1a to 218-1c and the plurality of second metal oxide layers 218-2a to 218-2c having different refractive indices. In this instance, the first metal oxide layer 218-1a to 218-1c and the second metal oxide layer 218-2a to 218-2c may be not made of pure metal and have strong binding strength with the epi layer, so that a peeling problem does not occur, and thus defect in the semiconductor light-emitting element 200C itself or defect in a product such as a display device can be prevented.

### [Fifth Embodiment]

FIG. 30 is a cross-sectional view illustrating a semiconductor light-emitting element according to a fifth embodiment.

The fifth embodiment is the same as the first to fourth embodiments except for the metal oxide layer 218. In the fifth embodiment, components having the same shape, structure, and/or function as those in the first to fourth embodiments are given the same drawing reference numerals and a detailed description is omitted.

Referring to FIG. 30, the semiconductor light-emitting element 200D according to the fifth embodiment may comprise a light-emitting layer 211 to 213, a first electrode 215, a second electrode 216, a passivation layer 217, and a metal oxide layer 218. The semiconductor light-emitting element 200D according to the fifth embodiment may be a red lateral-type semiconductor light-emitting element, a green semiconductor light-emitting element, and/or a blue semiconductor light-emitting element.

In the embodiment, the metal oxide layer 218 may be disposed on the lower side of the light-emitting layer 211 to 213. In addition, the metal oxide layer 218 may be disposed on the lateral part of the light-emitting layer 211 to 213. For example, the metal oxide layer 218 may be disposed on a lateral surface of the first conductivity type semiconductor layer 211.

Meanwhile, the passivation layer 217 may be disposed on the lateral part of the light-emitting layer 211 to 213. For example, the passivation layer 217 may be disposed on the lateral surface of the first conductivity type semiconductor layer 211. In this instance, the metal oxide layer 218 may be disposed on the passivation layer 217 on the lateral part of the light-emitting layer 211 to 213. That is, the metal oxide layer 218 may be disposed on the passivation layer 217 along the perimeter of a lateral part of the light-emitting layer 211 to 213. For example, the metal oxide layer 218 may be horizontally overlapped with the passivation layer 217.

According to the fifth embodiment, the metal oxide layer 218 may be disposed on the passivation layer 217 along the perimeter of a lateral part of the light-emitting layer 211 to 213, so that damage to the light-emitting layer 211 to 213 (or epilayer) due to penetration of the etchant 231 can be prevented, as illustrated in FIG. 14. Accordingly, the emission failure of the semiconductor light-emitting element 200D can be prevented.

### [Sixth embodiment]

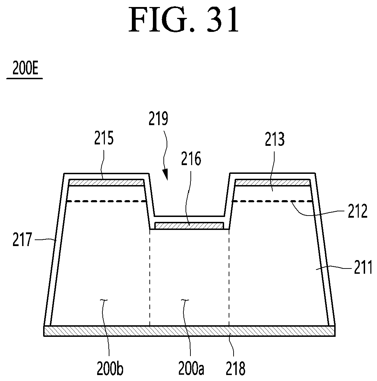

FIG. 31 is a cross-sectional view illustrating a semiconductor light-emitting element according to a sixth embodiment.

The sixth embodiment is the same as the first to fifth embodiments except for the shape of the light-emitting layer 211 to 213. In the sixth embodiment, components having the same shape, structure, and/or function as those of the first to fifth embodiments are given the same drawing reference numerals, and detailed descriptions thereof will be omitted.

Referring to FIG. 31, the semiconductor light-emitting element 200E according to the sixth embodiment may comprise a light-emitting layer 211 to 213, a first electrode 215, a second electrode 216, a passivation layer 217, and a metal oxide layer 218. The semiconductor light-emitting element 200E according to the sixth embodiment may be a red lateral-type semiconductor light-emitting element, a green semiconductor light-emitting element, and/or a blue semiconductor light-emitting element.

The light-emitting layer 211 to 213 may have a first region 200a and a second region 200b surrounding the first region 200a.

A recess 219 may be formed on the first region 200a of the light-emitting layer 211 to 213. The recess 219 may have a circular shape, but is not limited thereto.

An upper surface of the first region 200a, i.e., a bottom surface of the recess 219, may be positioned differently from an upper surface of the second region 200b of the light-emitting layer 211 to 213 by the recess 219. That is, the bottom surface of the recess 219 and the upper surface of the second region 200b of the light-emitting layer 211 to 213 may be positioned on different horizontal lines. The bottom surface of the recess 219 may be positioned lower than the upper surface of the second region 200b of the light-emitting layer 211 to 213.

The upper surface of the first conductivity type semiconductor layer 211 may be exposed by the recess 219. For example, the bottom surface of the recess 219 may be the upper surface of the first conductivity type semiconductor layer 211. The upper surface of the second conductivity type semiconductor layer 213 may be exposed by the second region 200b of the light-emitting layer 211 to 213. The upper surface of the second region 200b of the light-emitting layer 211 to 213 may be the upper surface of the second conductivity type semiconductor layer 213.

The first electrode 215 and the second electrode 216 may be disposed on the upper side of the light-emitting layer 211 to 213. The first electrode 215 may be disposed on the upper side of the second region 200b of the light-emitting layer 211 to 213, and the second electrode 216 may be disposed in the recess 219. The first electrode 215 may be in contact with the second region 200b of the light-emitting layer 211 to 213, that is, the upper surface of the second conductivity type semiconductor layer 213, and the second electrode 216 may be in contact with the bottom surface of the recess 219, that is, the upper surface of the first conductivity type semiconductor layer 211.

In the first to fifth embodiments, the upper surface of the first region 200a of the light-emitting layer 211 to 213 may be the upper surface of the second conductivity type semiconductor layer 213, and the upper surface of the second region 200b of the light-emitting layer 211 to 213 may be the upper surface of the first conductivity type semiconductor layer 211. In contrast, in the sixth embodiment, the upper surface of the first region 200a of the light-emitting layer 211 to 213, that is, the bottom surface of the recess 219, may be the upper surface of the first conductivity type semiconductor layer 211, and the upper surface of the second region 200b of the light-emitting layer 211 to 213 may be the upper surface of the second conductivity type semiconductor layer 213.

While in the first to fifth embodiments, the driving current flows from the center region (first region 200a) of the light-emitting layer 211 to 213 to the edge region (second region 200b), in the sixth embodiment, the driving current may flow from the edge region (second region 200b) of the light-emitting layer 211 to 213 to the center region (first region 200a).

While in the first to fifth embodiments, the size of the second electrode 216 may be greater than the size of the first electrode 215, in the sixth embodiment, the size of the first electrode 215 may be greater than the size of the second electrode 216.

Meanwhile, the display device described above may be a display panel. That is, in the embodiment, the display device and the display panel may be understood to have the same meaning. In the embodiment, the display device in the practical sense may comprise a display panel and a controller (or processor) that may control the display panel to display an image.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

### [Industrial Applicability]

The embodiment may be adopted in the display field for displaying images or information. The embodiment may be adopted in the display field for displaying images or information using a semiconductor light-emitting element. The semiconductor light-emitting element may be a micro-level semiconductor light-emitting element or a nano-level semiconductor light-emitting element.

For example, the embodiment may be adopted in a TV, a signage, a mobile terminal such as a mobile phone or a smart phone, display for computer such as laptop or desktop, a head-up display (HUDs) for an automobile, a backlight unit for display, display for VR, AR or mixed reality (MR), a light source, etc.

## Claims

1. A semiconductor light-emitting element, comprising:
a light-emitting layer having a first region and a second region surrounding the first region;
a first electrode on an upper side of the first region;
a second electrode on an upper side of the second region;
a passivation layer surrounding the light-emitting layer; and
a metal oxide layer on a lower side of the light-emitting layer,
wherein a thickness of the metal oxide layer is smaller than a thickness of the passivation layer.

2. The semiconductor light-emitting element of claim 1, wherein the thickness of the metal oxide layer is 1/3 or less of the thickness of the passivation layer.

3. The semiconductor light-emitting element of claim 1, wherein the metal oxide layer comprises a conductive oxide layer.

4. The semiconductor light-emitting element of claim 1, wherein the metal oxide layer comprises a dielectric oxide layer.

5. The semiconductor light-emitting element of claim 1, wherein the metal oxide layer comprises:
a conductive oxide layer; and
a dielectric oxide layer.

6. The semiconductor light-emitting element of claim 5, wherein the conductive oxide layer is disposed on the lower side of the light-emitting layer, and the dielectric oxide layer is disposed on a lower side of the conductive oxide layer.

7. The semiconductor light-emitting element of claim 6, wherein the dielectric oxide layer has a plurality of grooves.

8. The semiconductor light-emitting element of claim 5, wherein the dielectric oxide layer is disposed on the lower side of the light-emitting layer, and the conductive oxide layer is disposed on a lower side of the dielectric oxide layer.

9. The semiconductor light-emitting element of claim 8, wherein the conductive oxide layer has a plurality of grooves.

10. The semiconductor light-emitting element of claim 1, wherein the metal oxide layer comprises:
a plurality of first metal oxide layers; and
a plurality of second metal oxide layers between the plurality of first metal oxide layers.

11. The semiconductor light-emitting element of claim 10, wherein a sum of a total thickness of the plurality of first metal oxide layers and a total thickness of the plurality of second metal oxide layers is less than or equal to 1/2 of the thickness of the passivation layer.

12. The semiconductor light-emitting element of claim 1, wherein the metal oxide is disposed on a lateral part of the light-emitting layer.

13. The semiconductor light-emitting element of claim 12, wherein the metal oxide is horizontally overlapped with the passivation layer.

14. A display device, comprising:
a substrate;
a reflecting plate on the substrate;
an adhesive layer on the reflecting plate;
a plurality of semiconductor light-emitting elements configured to emit light of different colors on the adhesive layer; and
a first electrode wiring and a second electrode wiring on an upper side of each of the plurality of semiconductor light-emitting elements,
wherein the first electrode wiring and the second electrode wiring are connected to a first electrode and a second electrode, respectively, of each of the plurality of semiconductor light-emitting elements, and
wherein each of the plurality of semiconductor light-emitting elements comprises the semiconductor light-emitting element according to one of claims 1 to 13.
